# EUROPEAN PATENT APPLICATION

(11) **EP 4 538 796 A1**
(43) Date of publication of application: **16.04.2025**
(21) Application number: 23202760.7
(22) Date of filing: 10.10.2023
(51) Int. Cl.: G03F 7/20

(54) **VERTICALLY FEDERATED TRAINING OF A MACHINE LEARNING MODEL USED BY DIFFERENT PARTICIPANTS FOR CONFIGURING A SEMICONDUCTOR MANUFACTURING PROCESS**

(71) Applicant: ASML Netherlands B.V., 5500 AH Veldhoven (NL)
(72) Inventor: GKOROU, Dimitra, Veldhoven (NL); SHANKAR, Aditya, Veldhoven (NL); KHEDEKAR, Satej, Veldhoven (NL); CHEN, Yiyu Lydia, Veldhoven (NL); DECOUCHANT, Jérémie, Éric, Alphonse, Pierre, Veldhoven (NL)
(74) Representative: ASML Netherlands B.V.

(57) **Abstract**

Training a machine learning model used by different participants is described. Vertically federated learning is used to train the model with time series data sets. Time series data sets received from different participants are aligned, with each time series data set comprising different features corresponding to one or more samples common to each participant, but preserving the privacy of each time series data set for participants. First model parameters are received from a first participant. These are determined based on the aligning and first features provided by the first participant in a first time series data set. Second model parameters are received from a second participant. These are determined based on the aligning, second features provided by the second participant in a second time series data set, and semiconductor manufacturing process outputs associated with the second features. The model is trained based on the first and second model parameters.

## Description

### TECHNICAL FIELD

This description relates to vertically federated training of a machine learning model used by different participants for configuring a semiconductor manufacturing process.

### BACKGROUND

A lithographic projection apparatus can be used, for example, in the manufacture of integrated circuits (ICs). Lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

A patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatus, the pattern on the entire patterning device is transferred onto one target portion in one operation. Such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

One or more metrology processes, performed by various metrology systems, are also typically involved in the patterning process. The metrology systems, the lithographic apparatus, and other machines and/or tools associated with a patterning process typically require maintenance, calibration, and/or other upkeep operations over time.

### SUMMARY

Machine learning models may be used to predict needed maintenance, calibrations, control adjustments (e.g., corrections), part degradation and/or replacement need, remaining useable life, and/or other information for lithographic apparatuses, metrology systems, and other machines and/or tools involved in a patterning process. The patterning process may be a semiconductor lithography process, for example. These machine learning models are trained to link time series apparatus, system, machine, and/or tool data (e.g., apparatus set points, process parameters, etc., as they change over time) to time series product performance data (e.g., impact on measured product characteristics as the impact changes over time) to make predictions for the apparatuses, systems, machines, and/or tools. However, despite the advantages these models may provide, they are not widely adopted because apparatus, system, machine, and/or tool data may be generated by, and be confidential to a supplier (e.g., a first potential participant whose data might be used to help train a model); while the product performance data is often generated by, and confidential to, a customer (e.g., a second potential participant whose data might be used to train the same model). Because of the confidential nature of data from each potential participant's perspective (e.g., the supplier or the customer in this example), neither participant is typically willing to share data needed to train a machine learning model.

Advantageously, in the present systems and methods, vertically federated learning is used to train a machine learning model with time series data sets. Time series data sets received from different participants (e.g., a supplier, a customer, etc.) are aligned, with each time series data set comprising different features corresponding to one or more samples common to each participant, but preserving the privacy of each time series data set for participants (e.g., as described below). First model parameters are received from a first participant. These are determined based on the aligning and first features provided by the first participant in a first time series data set. Second model parameters are received from a second participant. These are determined based on the aligning, second features provided by the second participant in a second time series data set, and semiconductor manufacturing process outputs associated with the second features. The model is trained based on the first and second model parameters.

For example, according to an embodiment, there is provided a method for training a machine learning model used by different participants for configuring a semiconductor manufacturing process. The method comprises aligning time series data sets received from the different participants. Each time series data set comprises different features corresponding to one or more samples common to each participant. The aligning is configured to preserve privacy of each time series data set for each participant. The method comprises receiving, from a first participant, first model parameters (e.g., H1 as described herein) determined based on the aligning and first features provided by the first participant in a first time series data set. The method comprises receiving, from a second participant, second model parameters (e.g., H2 as described herein) determined based on the aligning, the second features provided by the second participant in a second time series data set, and semiconductor manufacturing process outputs associated with the second features. The method comprises training the machine learning model based on the first model parameters and the second parameters.

In some embodiments, the method comprises, responsive to the training, using the machine learning model for inference. Inference comprises: predicting needed maintenance for equipment used for the semiconductor manufacturing process, predicting part degradation and/or replacement need for one or more parts of the equipment, predicting a remaining useable life of the equipment, determining a feedforward correction for the semiconductor manufacturing process, determining a feedback correction for the semiconductor manufacturing process, and/or predicting a calibration setting for the equipment. In some embodiments, the inference is based on new equipment operational and/or performance data, and/or new on product performance data associated with the semiconductor manufacturing process. The new equipment operational and/or performance data, and/or the new on product performance data is provided to the trained machine learning model to cause the trained machine learning model to output a predicted maintenance need, a predicted part degradation and/or replacement need, a predicted remaining useable life of the equipment, a feedforward correction, a feedback correction, and/or a predicted calibration setting.

In some embodiments, the method comprises pre-processing, for the second participant, the second time series data set and the second features, and determining the second model parameters based on the pre-processing. In some embodiments, the pre-processing comprises identifying an order of a time series process using autocorrelation and partial autocorrelation plots. In some embodiments, identifying the order of the time series process comprises determining a number of autoregressive terms, a differencing order, moving average terms, and/or seasonal orders.

In some embodiments, the aligning, determining the first parameters, determining the second parameters, and training, are performed according to a vertical federated learning framework.

In some embodiments, the first and/or second parameters comprise weights, time series parameters including an order and a seasonal order, and/or a number of exogenous features.

In some embodiments, the one or more samples comprise semiconductor wafers.

In some embodiments, the features comprise semiconductor manufacturing process data values associated with equipment used for the semiconductor manufacturing process and/or products produced by the semiconductor manufacturing process. In some embodiments, the features comprise data values associated with a lithographic apparatus and corresponding product performance data values. In some embodiments, the data values are sensor reading values from a sensor of the lithographic apparatus. In some embodiments, the sensor is one of: an alignment sensor, a leveling sensor, an aberration measurement sensor, a temperature sensor, a current and/or power sensor, a vibration sensor, an accelerometer, a pressure sensor, or an illuminance sensor.

In some embodiments, the product performance data values relate to one or more of: pattern position error (PPE), alignment residual error, overlay, focus error, Critical Dimension (CD), yield of the semiconductor manufacturing process, Edge Placement Error (EPE), defects, defect rate, or electrical test data.

In some embodiments, the aligning comprises entity alignment. In some embodiments, entity alignment comprises a Private Set Intersection (PSI) scheme. In some embodiments, the PSI scheme comprises signature-and-encryption and/or oblivious transfer.

In some embodiments, the semiconductor manufacturing process outputs associated with the second features are owned and kept private for the second participant.

In some embodiments, the different participants are prevented from colluding with one another. In some embodiments, the different participants are physically located remotely from each other. In some embodiments, the participants comprise one active participant, and one or more auxiliary participants. There is one coordinator responsible for generating random data used for secure matrix multiplication, and does not have access to the time series data sets data. The random data generated by the coordinator is configured to be consumed by other participants during training. Secure matrix multiplication is used for optimizing machine learning model parameters and/or predictions. In some embodiments, the method comprises providing an isolated computing environment for each participant using Intel Software Guard Extensions (SGX), or through a trusted third-party.

In some embodiments, the method comprises providing encrypted communication between the different participants, such that communications between pairs of participants are kept private and are not discoverable to other participants.

In some embodiments, the machine learning model comprises a neural network, a traditional time series model, and/or an autoregressive tree. For example, in some embodiments, the machine learning model comprises the neural network, and the neural network is trained using a variant of split learning architecture. Inferences may be provided from a trained neural network to participants by a federator. As another example, in some embodiments, the machine learning model comprises the traditional time series model, and the traditional time series model is trained using secret sharing techniques for input feature values for autoregressive, moving average, and exogenous terms associated with the time series data sets from each participant. As a third example, in some embodiments, the machine learning model comprises the autoregressive tree, and the autoregressive tree is trained using secret sharing techniques and/or by communicating a maximum autoregressive lag, T, such that each participant can align their exogenous variables to start from a Tth step onward. In some embodiments, each participant distributes local features or output using secret sharing to other participants, and each participant produces a local inference result which is aggregated by a requesting party, such that absence of a single federator provides flexibility in choosing an aggregator, and such that a participant requiring inference results can directly aggregate individual shares from other participants for obtaining a final result without having the federator act as a middleman.

According to another embodiment, there is provided a computer program product comprising a non-transitory computer readable medium having instructions recorded thereon, the instructions when executed by a computer implementing the method described above.

According to another embodiment, there is provided a system comprising a computer configured to execute instructions stored on a non-transitory computer readable medium, the computer configured to implement the method described above based on the instructions.

According to another embodiment, there is provided a computer program product comprising a non-transitory computer readable medium having instructions recorded thereon, the instructions defining a trained machine learning model configured to be executed by computers associated with different participants for configuring a semiconductor manufacturing process. The trained machine learning model is trained as described above.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts.
Fig. 1 shows a block diagram of various subsystems of a lithography system, according to an embodiment.
Fig. 2 illustrates a summary of operations of a present method for training a machine learning model used by different participants for configuring a semiconductor manufacturing process, according to an embodiment.
Fig. 3 illustrates an example of privacy preserving entity alignment, according to an embodiment.
Fig. 4 illustrates time-series data pre-processing by a participant, model parameter determination, and exchange of information between participants, according to an embodiment.
Fig. 5 illustrates security and confidentiality maintaining features associated with the method from Fig. 2, according to an embodiment.
Fig. 6 illustrates an architecture that may be used to train a model comprising long short term memories (LSTMs) or recurrent neural networks (RNNs), and/or other components, according to an embodiment.
Fig. 7 illustrates splitting and secretly sharing the (traditional time series) model coefficients A, input feature values X, and output values Y between three different example participants, according to an embodiment.
Fig. 8 illustrates an example of inferencing with a split neural network architecture and a federator, according to an embodiment.
Fig. 9 illustrates inferencing with secret sharing based schemes for vertically federated learning, according to an embodiment.
Fig. 10 is a block diagram of an example computer system, according to an embodiment.
Fig. 11 is a schematic diagram of a lithographic projection apparatus similar to and/or the same as the lithographic apparatus illustrated in Fig. 1, according to an embodiment.

### DETAILED DESCRIPTION

Complex, data driven technologies play an increasing role in business for service providers and their customers. Data generated by or for these technologies may include information which can be monetized. For this and other reasons, customers may be reluctant to share data with service providers, and vice versa, since it may be difficult to assess the value of data before it is shared.

Data based prediction models are used in many solutions for diverse problems. A machine learning model is an example of a prediction model. One way to train a machine learning model uses labeled training data. The labeled training data often includes process data (e.g., for a lithography process) and corresponding performance data. The performance data is determined, for example, by machine and/or human inspection and/or other methods. For some service providers, a prediction model may require training with data which belongs to, and/or is only available from a customer. Conversely, for some customers, a prediction model may require training data which belongs to, and/or is only available from a service provider. As described below, suppliers and/or customers are examples of participants whose data may be used for vertically federated training of a machine learning model (that can be used by the different participants) for configuring a semiconductor manufacturing process, while keeping data from each participant confidential from other participants. In general, a participant (e.g., a supplier, a customer, etc.) is any entity willing to contribute data to training the model so that that participant can use the model together with other participants to configure a semiconductor manufacturing process (though other applications of the principles described below are contemplated).

The present systems and methods comprise a data control and prediction model training architecture that supports training on supplier, customer, and/or other participant data without the need for the supplier, customer, and/or other participants to share that data with each other. Advantageously, this architecture may reduce or eliminate a risk that data (and/or other intellectual property belonging to a participant) is unintentionally disseminated from a participant, while still being able to provide an optimized prediction model. The present systems and methods are configured to facilitate the training of complex models using data from multiple participants, without the need to share that data between participants. This allows training of a prediction model using various participant's data such that an optimal model can be generated for participants, without introducing (or at least reducing) the risk of unintentional data dissemination from the participants.

For example, the present systems and methods may be useful for several applications associated with a patterning process such as predictive maintenance, and lithography apparatus (e.g., scanner) calibration and control, where scanner (or lithography apparatus) inline data is linked to on product performance (OPP) impact (e.g., impact on measured product characteristics as the characteristics change over time) via machine learning models. These principles may also be applied to metrology and/or other systems and/or tools associated with the patterning process.

For predictive maintenance applications, predicting the impact of equipment degradation on product performance ahead of time (so that part swaps can be made in planned downtimes) is helpful. Scanner and/or other equipment data and on-product data typically comprise different sources of noise and/or systematic error, for example. OPP impact typically results from degradation of multiple parts of a scanner and/or other equipment, but it is often unclear which parts are degrading and impacting product performance. In addition, given that on-product impact often arises from multiple sources with different degradation rates, it is helpful to model OPP based on each source of equipment degradation and then combine these effects to estimate a remaining useful lifetime of a part linked to OPP impact. By combining scanner and/or other equipment and on-product data sources, the present systems and methods produce models that accurately map equipment degradation to OPP.

For scanner calibration and control applications, a scanner drift fingerprint is used periodically as a basis for control settings provided via feedback and/or feedforward loops (e.g., feedforward or feedback corrections). In feedforward corrections, a model may map scanner inline data to OPP, and adjust the exposure of a substrate such as a wafer to correct for scanner drifts. In feedback corrections, a model can be used to adjust the exposure in a feedback loop (based on the map of scanner inline data to OPP) as it may be that some exposures are at infrequent time intervals and as a result, the scanner status has changed between consecutive exposures. Scanner calibration similarly benefits from linking inline scanner data to OPP, and results in more effective layout-independent and layer scanner correction and calibration settings.

Despite the advantages of these models, they have not been widely adopted because they typically require confidential data for training, which is not typically available. For example, OPP data is often customer (e.g., one example participant) sensitive while scanner inline sensor measurements (for example) and/or other data may be supplier (e.g., another example participant) sensitive. Typically, in order to link scanner inline sensor measurements (in this example) to OPP, the scanner inline measurements are used as input features to a model which predicts OPP. OPP data (e.g., labels) and scanner inline sensor measurements (e.g., features) come from independent sources, (i.e., the data is feature-partitioned), and these potential participants are often unwilling to share this data with each other.

Prior solutions to this data confidentiality problem involve models trained with small amounts of non-confidential data from each participant, which then generally do not generate predictions accurate enough to be useful. In other (also so far inadequate) solutions, data may be aggregated in a central location, even though potential participants prefer this data to remain private, which raises security concerns. Data is often produced in different places (e.g., via a scanner, metrology tools, etc.) and can be stored in different locations with different access rights. This is typically ignored in most prior solutions, which are configured such that they only consider data aggregated in one place. The time-dependent nature of data is also commonly ignored in prior solutions (e.g., prior models are not trained to aggregate time dependent data from different sources).

In view of the often sensitive and/or confidential nature of each participant's data and the other issues described above, the present systems and methods are configured to train a model in a privacy-preserving manner (i.e., such that a participant's data does not have to physically leave the participant's premises - which means that small or large datasets can be used). Moreover, the present systems and methods are configured such that different participants cannot infer other participants' confidential data from the model (i.e., a model inversion attack). The present systems and methods are also configured to handle the time series nature of the data involved. For example, on product issues and/or scanner degradation may appear as drifting signals with drifts of different types (e.g., incremental, sudden, recurring, gradual, etc.). As a result, scanner data may have a drift effect over time which biases measured values. The present systems and methods are configured such that this does not negatively affect the performance of a model.

In the present systems and methods, time series data from different participants (e.g., inline scanner measurements, OPP data, etc.) is linked using timeseries machine learning models trained under a vertical federated learning framework. This framework facilitates training timeseries models while respecting the confidentiality of participant data. As described below, identifiers, timestamps, and/or information associated with the time series data from each participant can be used to link common samples. A full dataset can be viewed as feature-partitioned, with the features (e.g., scanner measurements) residing in a different location than labels (e.g., OPP data).

The present methods, software, and/or methods may be used as stand-alone tools and/or techniques, and/or or used in conjunction with other semiconductor manufacturing processes, to enhance the accurate transfer of complex designs to physical wafers. Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "patterning device" or "reticle", "wafer", or "die" in this text should be considered as interchangeable with the more general terms "mask", "substrate", and "target portion", respectively. In addition, it should be noted that the methods, software, and/or systems described herein may have many other possible applications in diverse fields such as language processing systems, self-driving cars, medical imaging and diagnosis, semantic segmentation, denoising, chip design, electronic design automation, etc. The present methods, software, and/or systems may be applied in any fields where quantifying uncertainty in machine learning model predictions is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

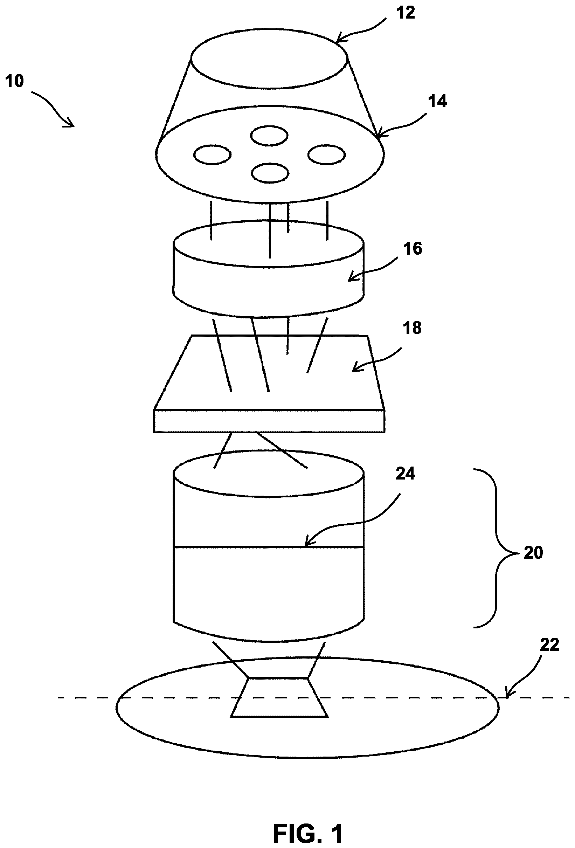

As a brief introduction, Fig. 1 illustrates an exemplary lithographic projection apparatus 10. Major components include a radiation source 12, which may be a deep-ultraviolet (DUV) excimer laser source or other type of source including an extreme ultra violet (EUV) source, illumination optics 14, 16 that shape radiation from the source 12; a patterning device 18; and transmission optics 20 that project an image of the patterning device pattern onto a substrate plane 22. An adjustable filter or aperture 24 at the pupil plane of the projection optics may restrict the range of beam angles that impinge on the substrate plane 22.

In lithographic projection apparatus 10, source 12 provides illumination (i.e. radiation) to patterning device 18 and projection optics 20 direct and shape the illumination, via patterning device 18, onto a substrate. Various patterns on or provided by a patterning device may have different process windows. i.e., a space of processing variables under which a pattern will be produced within specification. Examples of pattern specifications that relate to potential systematic defects include checks for necking, line pull back, line thinning, critical dimension (CD), edge placement, overlapping, resist top loss, resist undercut and/or bridging. The process window of the patterns on a patterning device or an area thereof may be obtained by merging (e.g., overlapping) process windows of each individual pattern. The boundary of the process window of a group of patterns comprises boundaries of process windows of some of the individual patterns. In other words, these individual patterns limit the process window of the group of patterns. These patterns can be referred to as "hot spots" or "process window limiting patterns (PWLPs)," which are used interchangeably herein. When controlling a part of a patterning process, it is possible and economical to focus on the hot spots. When the hot spots are not defective, it is most likely that other patterns are not defective.

Lithographic apparatus 10 may form part of a lithographic cell, which includes apparatuses to perform pre- and post-exposure processes on a substrate. Conventionally these include one or more spin coaters to deposit one or more resist layers, one or more developers to develop exposed resist, one or more chill plates and/or one or more bake plates. A substrate handler picks up one or more substrates from an input/output port, moves them between the different process apparatuses and delivers them to a loading bay of lithographic apparatus 10. These apparatuses, which are often collectively referred to as the track, are under the control of a track control unit which is itself controlled by the supervisory control system, which also controls the lithographic apparatus via a lithography control unit. Thus, the different apparatuses can be operated to maximize throughput and processing efficiency.

In order that a substrate that is exposed by the lithographic apparatus is exposed correctly and consistently and/or in order to monitor a part of the patterning process (e.g., a device manufacturing process) that includes at least one pattern transfer step (e.g., an optical lithography step), it is desirable to inspect a substrate or other object to measure or determine one or more properties such as alignment, overlay (which can be, for example, between structures in overlying layers or between structures in a same layer that have been provided separately to the layer by, for example, a double patterning process), line thickness, critical dimension (CD), focus offset, a material property, etc. Accordingly, a manufacturing facility in which a lithocell is located also typically includes a metrology system that measures some or all of the substrates that have been processed.

As described above, machine learning models may be used to predict needed maintenance, calibrations, control adjustments (e.g., corrections), part degradation and/or replacement need, remaining useable life, and/or other information for these lithographic apparatuses, metrology systems, and other machines and/or tools involved in a patterning process. Advantageously, in the present methods, software, and/or systems, vertically federated learning is used to train a machine learning model with time series data sets. Time series data sets received from different participants (e.g., a supplier, a customer, etc. - any entity willing to contribute data to training the model so that they can use the model to configure a semiconductor manufacturing process) are aligned, with each time series data set comprising different features corresponding to one or more samples common to each participant, but preserving the privacy of each time series data set for participants (e.g., as described below). First model parameters are received from a first participant. These are determined based on the aligning and first features provided by the first participant in a first time series data set. Second model parameters are received from a second participant. These are determined based on the aligning, second features provided by the second participant in a second time series data set, and semiconductor manufacturing process outputs associated with the second features. The model is trained based on the first and second model parameters. Once trained, the machine learning model may be used to predict needed maintenance, calibrations, control adjustments (e.g., corrections), part degradation and/or replacement need, remaining useable life, and/or other information for one or more of the lithographic apparatuses, metrology systems, and other machines and/or tools involved in a patterning process described above, without compromising the confidentiality of data from any participant (e.g., any service provider, customer, etc.).

In some embodiments, the machine learning model may be an empirical model that performs the operations of the method(s) described herein. The empirical model may predict outputs (e.g., needed maintenance, calibrations, control adjustments (e.g., corrections), part degradation and/or replacement need, remaining useable life, and/or other information) based on correlations between various inputs (e.g., machine set points, process window parameters, one or more characteristics of a mask or wafer image, one or more characteristics of a design layout, one or more characteristics of the patterning device, one or more characteristics of the illumination used in the lithographic process such as the wavelength, on product measurements, etc.). As an example, the empirical model may be any parameterized model. In an embodiment, the machine learning model (for example) may be and/or include mathematical equations, algorithms, plots, charts, networks (e.g., neural networks), and/or other tools and machine learning model components. For example, the machine learning model may be and/or include one or more neural networks having an input layer, an output layer, and one or more intermediate or hidden layers. In an embodiment, the one or more neural networks may be and/or include deep neural networks (e.g., neural networks that have one or more intermediate or hidden layers between the input and output layers).

As an example, the one or more neural networks may be based on a large collection of neural units (or artificial neurons). The one or more neural networks may loosely mimic the manner in which a biological brain works (e.g., via large clusters of biological neurons connected by axons). Each neural unit of a neural network may be connected with many other neural units of the neural network. Such connections can be enforcing or inhibitory in their effect on the activation state of connected neural units. In an embodiment, each individual neural unit may have a summation function that combines the values of all its inputs together. In an embodiment, each connection (or the neural unit itself) may have a threshold function such that a signal must surpass the threshold before it is allowed to propagate to other neural units. These neural network systems may be self-learning and trained, rather than explicitly programmed, and can perform significantly better in certain areas of problem solving, as compared to traditional computer programs. In an embodiment, the one or more neural networks may include multiple layers (e.g., where a signal path traverses from front layers to back layers). In an embodiment, back propagation techniques may be utilized by the neural networks, where forward stimulation is used to reset weights on the "front" neural units. In an embodiment, stimulation and inhibition for the one or more neural networks may be freer flowing, with connections interacting in a more chaotic and complex fashion. In an embodiment, the intermediate layers of the one or more neural networks include one or more convolutional layers, one or more recurrent layers, and/or other layers.

The one or more neural networks may be trained as described herein using sets of training data. The training data may include an input object (typically a vector, which may be called a feature vector) and a desired output value (also called the supervisory signal). A training algorithm analyzes the training data and adjusts the behavior of the neural network by adjusting the parameters (e.g., weights of one or more layers) of the neural network based on the training data. For example, given a set of N training samples of the form {(x₁,y₁), (x₂,y₂), ... , (x_{N},y_{N})} such that xᵢ is the feature vector of the i-th example and yᵢ is its supervisory signal, a training algorithm seeks a neural network g: X → Y, where X is the input space and Y is the output space. A feature vector is an n-dimensional vector of numerical features that represent some object. The vector space associated with these vectors is often called the feature space. After training, the neural network may be used for making predictions using new inputs.

With prior prediction models generated and/or trained by service providers and/or other centralized systems, training data is collected from remote systems (e.g. associated with customers of the service provider) on a central system (e.g. associated with the service provider). Unintentional dissemination of information from the remote systems was often a concern. The present systems and methods were developed to address these and other disadvantages.

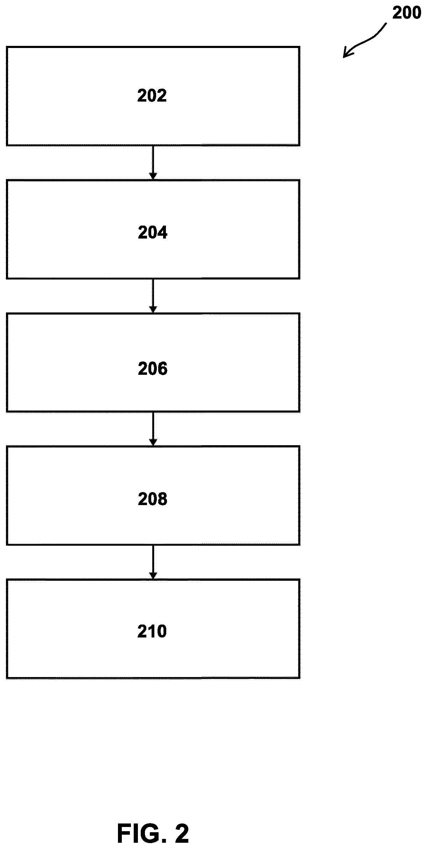

Fig. 2 illustrates a summary of operations of a present method 200 for training a machine learning model used by different participants for configuring a semiconductor manufacturing process. The operations of method 200 are performed according to a vertical federated learning framework. In this framework, a participant may be, for example, a supplier, a customer, and/or any other entity willing to contribute data to training the model so that they can use the model to configure a semiconductor manufacturing process. The different participants may be physically located remotely from each other, for example. Method 200 is described with reference to two participants (e.g., a supplier and a customer), but this is not intended to be limiting. The operations of method 200 may be applied for any number and/or type of participants, to train one or more machine as described herein (and/or use one more such trained machine learning models). The operations of method 200 are intended to be illustrative. In some embodiments, method 200 may be accomplished with one or more additional operations not described, and/or without one or more of the operations discussed. Additionally, the order in which the operations of method 200 are illustrated in Fig. 2 and described below is not intended to be limiting. For example, one or more of these operations may not occur sequentially in time, but instead in parallel.

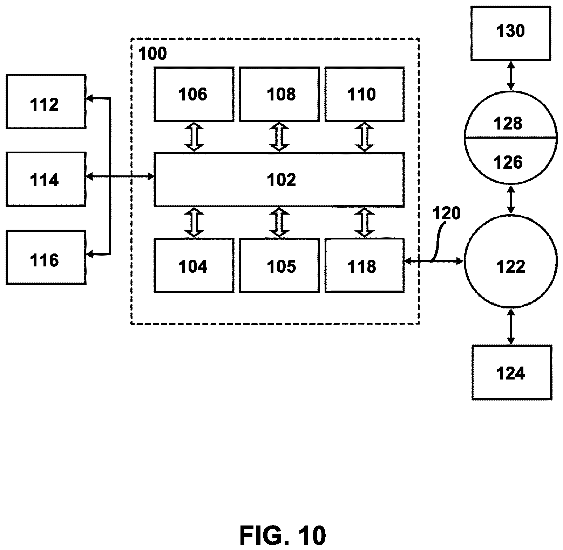

In some embodiments, one or more portions of method 200 may be performed by, implemented in, and/or controlled by one or more processing devices (e.g., a digital processor, an analog processor, a digital circuit designed to process information, an analog circuit designed to process information, a state machine, and/or other mechanisms for electronically processing information, as described with respect to Fig. 10 below). The one or more processing devices may include one or more devices executing some or all of the operations of method 200 in response to instructions stored electronically on an electronic storage medium. The one or more processing devices may include one or more devices configured through hardware, firmware, and/or software to be specifically designed for execution of one or more of the operations of method 200 (e.g., see discussion related to Fig. 10 below).

At an operation 202, time series data sets received from the different participants are aligned. Each time series data set comprises different features corresponding to one or more samples common to each participant. The one or more samples may comprise semiconductor wafers, for example, and/or other samples. The aligning is configured to preserve privacy of each time series data set for each participant. In other words, when there are several participants collaborating to jointly train a model, it is first necessary to ensure that all of the participants use features corresponding to the same samples (e.g., the same wafer in a semiconductor example). If this is not done, then there may be training samples for which only a partial set of features (or data) exist (i.e., data for a certain sample may only exists in a subset of the datasets received from participants). The process of identifying the common samples between multiple participants is called alignment - operation 202. Operation 202 may be similar to an inner-join of tables, for example, but is performed in a privacy-preserving way.

Several entity alignment approaches exist for matching samples in a privacy-preserving manner. One of these schemes can be applied first to link samples. In some embodiments, the aligning comprises entity alignment. Entity alignment may comprise a Private Set Intersection (PSI) scheme, for example. The PSI scheme may comprise signature-and-encryption and/or oblivious transfer, and/or other schemes.

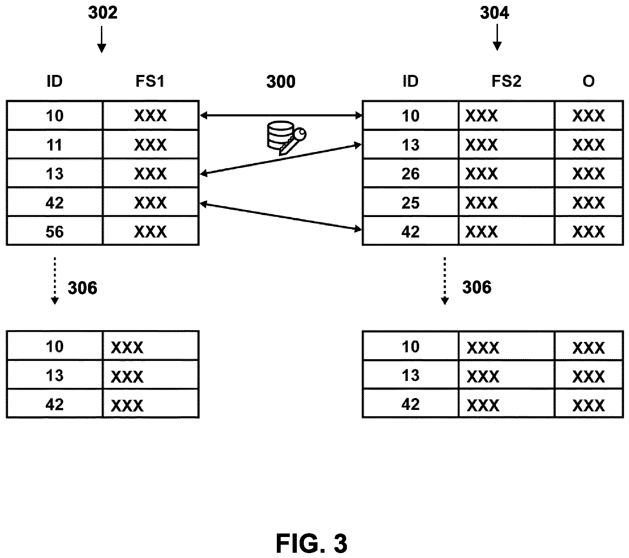

Fig. 3 illustrates an example of privacy preserving entity alignment 300. Time series data sets 302 and 304 received from different participants are aligned. Each time series data set 302 and 304, with samples identified by an ID number and/or timestamp (or some other unique identifier) comprises different features (e.g., feature set FS1 from a first participant, and feature set FS2 from a second participant) corresponding to one or more samples common to each participant. The one or more samples may comprise semiconductor wafers, for example, and/or other samples. The features may comprise semiconductor manufacturing process data values associated with equipment used for the semiconductor manufacturing process and/or products produced by the semiconductor manufacturing process. In some embodiments, the features comprise data values associated with a lithographic apparatus and corresponding product performance data values. The data values may be sensor reading values from a sensor of the lithographic apparatus and/or other data values. For example, the sensor may be an alignment sensor, a leveling sensor, an aberration measurement sensor, a temperature sensor, a current and/or power sensor, a vibration sensor, an accelerometer, a pressure sensor, an illuminance sensor, and/or other sensors. The product performance data values relate to one or more of pattern position error (PPE), alignment residual error, overlay, focus error, Critical Dimension (CD), yield of the semiconductor manufacturing process, Edge Placement Error (EPE), defects, defect rate, electrical test data, and/or other information. Data set 304, in this example, also comprises outputs O (associated with feature set FS2). The examples mentioned as product performance data above are also examples of output values (O), e.g., things like overlay or yield. FS2 could be a secondary performance metric or sensor measurement. O is used to indicate a primary performance metric that is to be predicted. For example, if predicted overlay is to be the primary metric, O, other metrics like EPE or defect rate could be used as FS2. Participants can identify the common samples without leaking private information. The double-sided arrows indicate the rows corresponding to the same sample across participants and the dashed arrows represent the final set of data samples after entity alignment.

Returning to Fig. 2, operation 204 comprises receiving, from a first participant, first model parameters (H1) determined based on the aligning (e.g., alignment 300 shown in Fig. 3) and first features (e.g., feature set FS1) provided by the first participant in a first time series data set (e.g. 302 shown in Fig. 3) and/or other information. The first model parameters (H1) may be hyperparameters, for example. Hyperparameters may be or include things like time series parameters (e.g., order and seasonal order), the number of features, etc.. These are used to control the learning process and are not necessarily "learned" during training. These may be derived through pre-processing or set manually, and/or determined in other ways. In contrast, model parameters may be be things like the weights which would be learned during the training process using gradient descent for example.

The first model parameters may comprise weights, time series parameters including an order and a seasonal order, a number of exogenous features (e.g., a feature count for SARIMAX - seasonal auto regressive integrated moving average with exogenous factors), and/or other parameters. Operation 204 is configured such that semiconductor manufacturing process outputs associated with the features provided by the first participant are owned by and kept private for the first participant.

Operation 206 comprises receiving, from a second participant, second model parameters (or hyperparameters H2) determined based on the aligning (e.g., alignment 300 shown in Fig. 3), second features (e.g., feature set FS2) provided by the second participant in a second time series data set (e.g., 304 shown in Fig. 3), semiconductor manufacturing process outputs (e.g., O shown in Fig. 3) associated with the second features, and/or other information. Like the first model parameters, the second model parameters may comprise weights, time series parameters including an order and a seasonal order, a number of exogenous features, and/or other parameters. The features provided by the second participant may again include semiconductor manufacturing process data values associated with equipment used for the semiconductor manufacturing process and/or products produced by the semiconductor manufacturing process; data values associated with a lithographic apparatus and corresponding product performance data values such as sensor reading values from a sensor of the lithographic apparatus and/or other data values (e.g., an alignment sensor, a leveling sensor, an aberration measurement sensor, a temperature sensor, a current and/or power sensor, a vibration sensor, an accelerometer, a pressure sensor, an illuminance sensor, and/or other sensors that output information associated with product performance data values relate to one or more of pattern position error (PPE), alignment residual error, overlay, focus error, Critical Dimension (CD), yield of the semiconductor manufacturing process, Edge Placement Error (EPE), defects, defect rate, electrical test data, etc.). Operation 206 is configured such that semiconductor manufacturing process outputs associated with the features provided by the second participant are owned by and kept private for the second participant.

In some embodiments, operation 206 comprises pre-processing, for the second participant, the second time series data set and the second features, and determining the second model parameters based on the pre-processing. Pre-processing may comprise identifying an order of a time series process using autocorrelation and partial autocorrelation plots, for example. Identifying the order of the time series process comprises determining a number of autoregressive terms, a differencing order, moving average terms, seasonal orders, and/or other information.

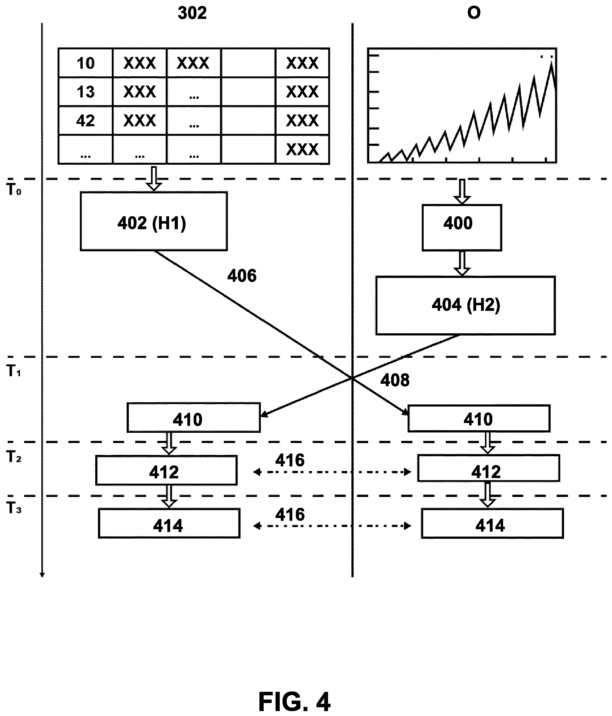

For example, Fig. 4 illustrates time-series data pre-processing 400 (at time T₀) by a participant, model parameter (H1 and H2) determination 402 and 404 (also at time T₀), and exchange (at time T₁) of information 406 (sending H1) and 408 (sending H2) between participants based on data (e.g., similar to and/or the same as 302 and O from Fig. 3) from each participant (e.g., divided into left and right portions in Fig. 4). In this way, each participant has joint knowledge of parameters (H1 and H2 in this example) that can be used for training a model. The participant who owns the data (e.g., 302 or O) analyses the (e.g., time series) data to identify information such as an order of the time series process (i.e., the number of autoregressive terms, differencing order, moving average terms, seasonal orders, etc.). In a semiconductor processing context, this may correspond to a customer, as overlay output (for example) may be what is predicted. This can be performed locally and then communicated to other participants. The other clients may also share the number of exogenous variables they own with the label owner.

Returning to Fig. 2, operation 208 comprises training the machine learning model based on the first model parameters and the second parameters. Secure matrix multiplication and/or other techniques may be used for optimizing machine learning model parameters and/or predictions, for example.

Operation 210 comprises, responsive to the training (e.g., operation 208), using the machine learning model for inference. Inference may comprise predicting needed maintenance for equipment used for the semiconductor manufacturing process, predicting part degradation and/or replacement need for one or more parts of the equipment, predicting a remaining useable life of the equipment, determining a feedforward correction for the semiconductor manufacturing process, determining a feedback correction for the semiconductor manufacturing process, and/or predicting a calibration setting for the equipment, among many other possible inferences. Inference may be based on new equipment operational and/or performance data, and/or new on product performance data associated with the semiconductor manufacturing process, for example. The new equipment operational and/or performance data, and/or the new on product performance data may be provided to the trained machine learning model to cause the trained machine learning model to output a predicted maintenance need, a predicted part degradation and/or replacement need, a predicted remaining useable life of the equipment, a feedforward correction, a feedback correction, a predicted calibration setting, etc.

After the model parameters are determined, the participants may separately and/or jointly train the model, following which the trained model is ready for inferencing. Based on the model type, the training procedure differs (as described below). In Fig. 4, operations 208 and 210 from Fig. 2 are illustrated by joint model training 412 (at time T₂), and joint inference 414 (at time T₃), operations. There may be an exchange 416 of intermediate information between participants during one or both of these operations. For example, information that might be exchanged may include secret shares of values or intermediate results when following secret-shared protocols for mathematical operations. In the case without secret sharing, the information exchanged is only between the participants and the federator; could be the gradients or the intermediate forward prop results, for example.

In method 200, and in Fig. 2-4, in some embodiments, the participants may comprise one active participant, and one or more auxiliary participants. There may also be one coordinator responsible for generating random data used for secure matrix multiplication, who does not have access to the time series data sets data. The random data generated by the coordinator is configured to be consumed by other participants during training. An isolated computing environment may be provided for each participant using Intel Software Guard Extensions (SGX), or through a trusted third-party, for example. Encrypted communication between the different participants may also be provided, such that communications between pairs of participants are kept private and are not discoverable to other participants. In method 200, the different participants are also prevented from colluding with one another.

For example, in vertical federated learning, participants are assumed to be "honest-but-curious." This means that no participant will maliciously violate the framework outlined in Fig. 4 and described above, but they will try to infer other participants' private information while adhering to the framework. Secret sharing implementations (as described below) require all participants to be able to send and receive information from one another.

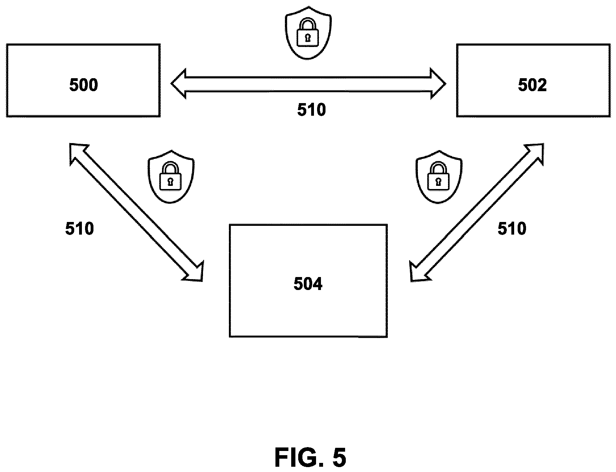

As an example, Fig. 5 illustrates security and confidentiality maintaining features associated with method 200 (Fig. 2). Fig. 5 illustrates an example active participant 500 (e.g., who may own labels or outputs, and possibly some features associated with time series datasets), an auxiliary participant 502 (e.g., who may own some features, but does not have access to labels or outputs, or intermediate information from active participant 500), and a coordinator 504 (e.g., who does not have access to any features, labels (outputs), or intermediate information from participants, and is only responsible for generating the random data described herein). Coordinator 504 may be provided by secure hardware such as, for example, Intel SGX, , etc. Encrypted communication 510 is provided between each participant.

In some embodiments, the machine learning model trained using method 200 (Fig. 2) comprises a neural network, a traditional time series model, an autoregressive tree, and/or other structures. For example, in some embodiments, the machine learning model comprises the neural network, and the neural network is trained using a variant of split learning architecture. The neural network may comprise long short term memory (LSTM), recurrent neural networks (RNN), and/or other components. In these embodiments, inferences from the trained neural network may be provided to participants by a federator. The federator may be a server, for example, that collects the intermediate outputs from the individual parties, and then uses these to perform the rest of the computation. This allows the model to learn from the collective knowledge of all the participating devices without having to exchange the actual private input data. This role may be taken up by the participant holding the true output values/labels since the final result of the computation needs to be compared with the true outputs for computing the loss and gradients.

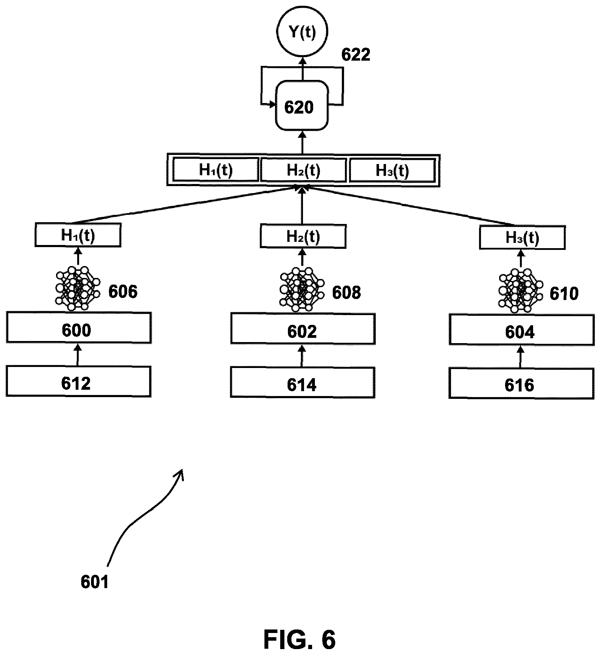

For example, to train a model comprising LSTMs or RNNs (and/or other components), an architecture 601 shown in Fig. 6 may be used. This is a variant of split learning architecture. Using knowledge of a time series data order, a number of recurrent units for an LSTM or RNN can be adjusted. Each participant 600, 602, 604 uses a local model 606, 608, 610 such as a feed-forward network to generate intermediate outputs H₁(t), H₂(t), and H₃(t) using its own features 612, 614, 616. The time dependence (t) indicates that the features and outputs are those corresponding to a time series. The intermediate outputs H₁(t), H₂(t), and H₃(t) are used as inputs to an LSTM (and/or RNN) model 620 that resides with a federator. By using the intermediate outputs instead of the features directly, architecture 601 ensures the privacy of participant's' features is maintained. The federator updates 622 the weights and/or other parameters of the LSTM model 620 and propagates output values Y(t) (e.g., gradients) back to the participants. Phrased another way federator updates 622 the weights and/or other parameters of the LSTM model 620 and propagates gradients of the model weights based on the computed output values Y(t) and the true outputs". Gradients are the partial derivatives of the loss with respect to a parameter to iteratively update that parameter. The loss function is the function that quantifies the comparison between the true outputs and computed outputs. Each participant 600-604 uses the received gradients to update the weights of the local model 606-610.

In some embodiments, the machine learning model comprises the traditional time series model, and the traditional time series model is trained using secret sharing techniques for input feature values for autoregressive, moving average, and exogenous terms associated with the time series data sets from each participant. In some embodiments, a traditional time series model comprises SARIMAX, a dynamic linear model, dynamic linear regression, and/or other traditional time series models. SARIMAX stands for Seasonal Autoregressive Integrated Moving Average models with Exogenous variables. Autoregressive and Moving Average time series models are well known, and SARIMAX extends the vanilla versions by accounting for seasonal patterns in the time series and external/exogenous variables.

For example, based on a (time) series (data) order, a linear equation for modelling the series may be generated, comprising autoregressive, moving average, exogenous, and/or seasonal terms. This equation is linear in terms of lagged values of the output variable, the lagged residual terms, and the exogenous variables as follows: y(t) = c + φ₁y(t-1) + ... + φₐy(t-a) + θ₁ε(t-1) + ... + θ_{b}ε(t-b) + β₁x₁(t) + ... + βₖxₖ(t) + ε(t). Here, y(t) is the output value at time t, ε represents the residual terms used in the moving average component, and x is for the exogenous features. The unknown coefficients, φ, θ, β, and c are jointly optimized by all clients.

This equation is a linear equation of the form XA = Y. Where A = [*A_ar, A_ma A_exog*] and comprises the coefficients needed to optimize. X = [X_ar, X_ma X_exog], represents the input feature values for the autoregressive, moving average, and exogenous terms. Y represents output values. Since the true values of X, A, and Y are provided and/or owned by different participants, each one is split and secretly shared with other participants.

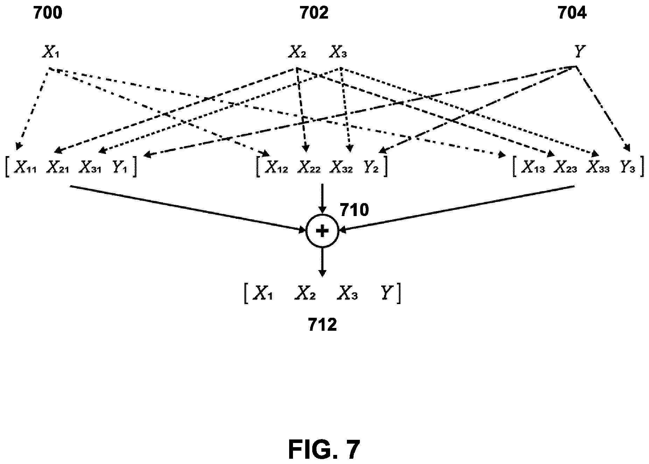

Fig. 7 illustrates splitting and secretly sharing the (traditional time series) input feature values X, and output values Y, between three different example participants 700, 702, and 704. In Fig. 7, participant 700 provides and/or owns feature value X₁, participant 702 provides and/or owns feature values X₂ and X₃, and participant 704 provides and/or owns output values Y. According to secret sharing techniques, X₁ is split into X₁₁, X₁₂, and X₁₃, and shared between the participants. Similar splitting and sharing is performed for X₂, X₃, and Y, as shown in Fig. 7. All of these can then be recombined 710 to produce the true feature vector 712.

Typically, SARIMAX is optimized using MLE (Maximum Likelihood Estimation), however, it is difficult to optimize this with secret sharing. Moreover, MLE is computationally expensive even under a centralized scheme, so developing a vertically partitioned version would incur additional communication costs making it infeasible. Two-step optimization is an alternative approach to optimize SARIMAX using least-squares. For a centralized algorithm, optimizing for the values of the coefficients A can be done using the Normal equation, and can be calculated as A_optimal = (X^{T}X)⁻¹(X^{T}Y). For vertically partitioned data, the present systems and methods use vertically federated learning compatible versions for corresponding matrix operations. Two-step optimization may comprise participants optimizing all coefficients excluding the moving average component. Residual terms are estimated using this model. Participants may jointly optimize for the coefficients of the moving average component using the estimated residuals.

For inference, each participant performs inference using their own local data. A participant needing results can be assigned as the aggregator for combining the data. This way, there is no single aggregator, so the inference results remain private to the participant requesting them. The flexible choice of the aggregator thus prevents one party from leveraging the inference results to their advantage.

In some embodiments, the machine learning model comprises the autoregressive tree, and the autoregressive tree is trained using secret sharing techniques and/or by communicating a maximum autoregressive lag, T, such that each participant can align their exogenous variables to start from a T^{th} step onward. For vertically federated learning compatibility, the present systems and methods perform entity alignment and identify the order of the time series in a manner similar to SARIMAX described above.

In some embodiments (e.g., when the machine learning model comprises the traditional time series model and/or the autoregressive tree), each participant distributes local features or output using secret sharing to other participants, and each participant produces a local inference result which is aggregated by a requesting party, such that absence of a single federator provides flexibility in choosing an aggregator, and such that a participant requiring inference results can directly aggregate individual shares from other participants for obtaining a final result without having the federator act as a middleman.

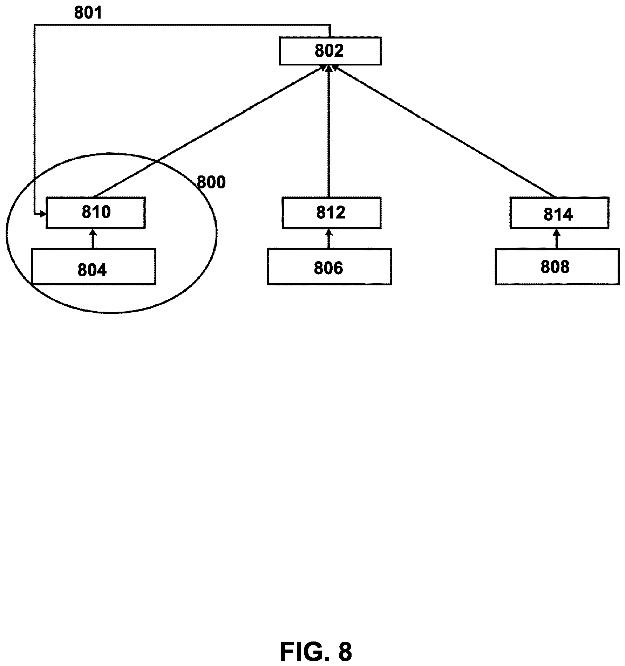

Fig. 8 illustrates an example of inferencing 800 with a split neural network architecture and a federator 802. Fig. 8 illustrates communicating 801 an inference output back to a requesting participant 810. Since the data 804, 806, 808 is feature partitioned (as described above), this architecture ensures that all participants 810, 812, 814 remain dependent on one another for querying results and prevents participants 810-814 from breaking-away from the group once a model has been trained. This architecture includes federator 802 since intermediate outputs from participants are required before further processing by the federator. However, since the federator in this example is the participant with the final inference result, such a scheme requires that the querying participants trust the federator to provide the correct results.

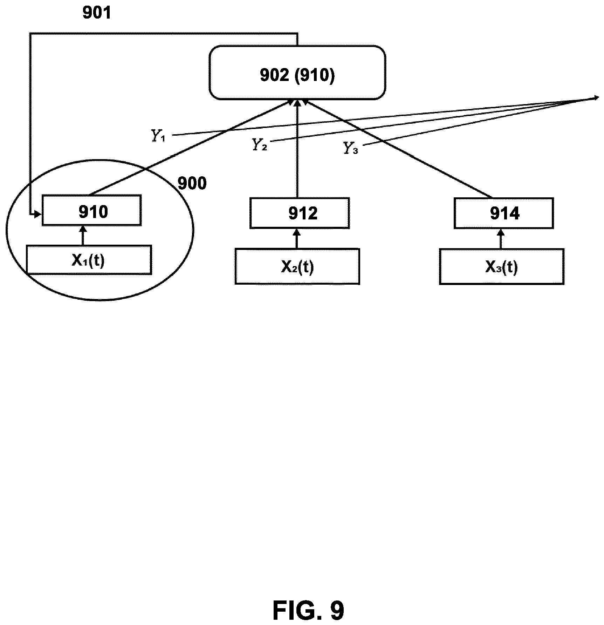

Fig. 9 illustrates inferencing 900 with secret sharing based schemes for vertically federated learning. In the case of SARIMAX and autoregressive tree models, each participant 910, 912, 914 distributes the local features or output (e.g., X₁(t), X₂(t), and X₃(t) in this example) using secret sharing to the other participants. Each party then produces a local inference result (Y₁, Y₂, Y₃ in this example) which is then aggregated by the requesting participant (aggregator 902 who is also participant 910 in this example). In Fig. 9, 901 represents Y = Y₁ + Y₂ + Y₃. The absence of a single federator in such a scheme makes it flexible in choosing the aggregator 902. Hence, the participant requiring the inference results can directly aggregate the individual inference results from other participants for obtaining the final result without having the federator act as a middleman.

The following information is provided to enhance understanding of some of the terms and concepts described above.

Federated Learning - federated learning can be classified into three categories depending on how the features and data are partitioned between participants. In Horizontal Federated Learning, participants have the same features, but own different samples. In Vertical Federated Learning, participants have features corresponding to the same sample, but have non-overlapping or partially overlapping features. In Federated Transfer Learning, participants have a low overlap in both the feature space and the sample space.

Split Learning - split learning architecture can be viewed as a partitioned neural network, with an initial part of the neural network residing with the participants. The remaining portion of the neural network resides with the federator, which may also be one of the participants holding an initial portion of the network. Since labels are assumed to reside only with one participant, it is assumed that the federator role is taken up by the label/output holder. During training, each participant performs a forward propagation using its local features and transfers the intermediate values to the federator. The federator performs a remaining forward pass, computes a loss, and returns gradients to the individual participants for parameter adjustment. Security in this scheme is typically achieved through differential privacy, i.e., noise is added to the intermediate values exchanged so that the true values are not leaked, preventing inversion attacks.

Secret Sharing - secret sharing is a way to perform secure computations by distributing data into shares and assigning them to participants. Each share is individually useless; the true value can only be obtained by aggregating the shares from multiple participants. For example, a number can be split into shares and shared with several participants. Each participant cannot identify the actual number, based on their local share alone, making the scheme secure. Moreover, it is possible to perform mathematical operations on secretly shared data items.

Secure Least Squares Optimization - for SARIMAX, the objective is to solve the least-squares solution using the formula (X^{T}X)⁻¹(X^{T}Y). An assumption is that there are N participants and X and Y have been distributed to these N participants as secret shares. From the formula, there is a need for the following three operations for vertically partitioned data: a. matrix transpose; b. matrix-matrix multiplication; and c. matrix inverse.

Matrix transpose: assume a matrix X is secretly shared with N participants. The shares are allocated in a way such that their sum returns X. Let participant indexed by i share be represented as Xi. Thus, we have X = X₁ + X₂ ... + Xₙ. X^{T} is therefore X₁^{T} + X₂^{T}....+Xₙ^{T}. So, to obtain the transpose, each participant can independently compute the transpose on their own local share. The sum of the resulting transposed matrices, i.e., the transposed shares, gives the transpose of X.

Matrix multiplication: for two matrices A and B of dimensions (p x q) and (q x r) respectively, there are algorithms to compute the product of A and B when these exist as secret shares. The result of the operation is product C = A X B which exists in a secret shared state across multiple clients. That is, C = C₁ + C₂ ... + Cₙ, where Cᵢ represents the share held by client i.

Matrix inverse: using the above two operations, it is possible to compute X^{T}X. For example, suppose the matrix C = X^{T}X, exists as shares C₁, C₂ ... , Cₙ. For the two-party case, the inverse C⁻¹ = (C₁ + C₂)⁻¹ is done the following way:
Participant 2 generates a non-singular random matrix P.

D = D₁ + D₂ = (C₁ x P) is computed using the secret shared version of matrix multiplication., where D₁ and D₂ are secret shares of participants 1 and 2.

Participant 2 computes D₂ + C₂ P and returns this to participant 1. Participant 1 adds D₁ to this result to obtain E = (C₁ + C₂) X P. Participant 1 locally computes E⁻¹ and shares this as E₁, E₂.

C⁻¹ can now be computed by multiplying E⁻¹ with P using the secret shared matrix multiplication. This will exist as secret shares across participants 1 and 2.

To extend the above method to the A-party case, the present systems and methods make the following modifications:
1. Compute C₁P, C₂P,..., Cₙ⁻¹P, like step 2 from the two-party case. Without loss of generality, assume participant N generates the matrix P.
2. All participants except N, sum all their shares and send them to participant 1.
3. Participant N sums his shares of C₁P, C₂P, .., Cₙ⁻¹P, adds this to CₙP and sends the result back to participant 1.
4. Participant 1 then computes {(C₁ + C₂ + .. + Cₙ)P}⁻¹ like step 3 of the two-step case. C⁻¹ can then be computed similar to the last step of the two-step case.

Fig. 10 is a block diagram that illustrates a computer system 100 that can assist in implementing the methods, flows, or the systems, and/or executing the software (e.g., executing a trained machine learning model) disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a network. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution.

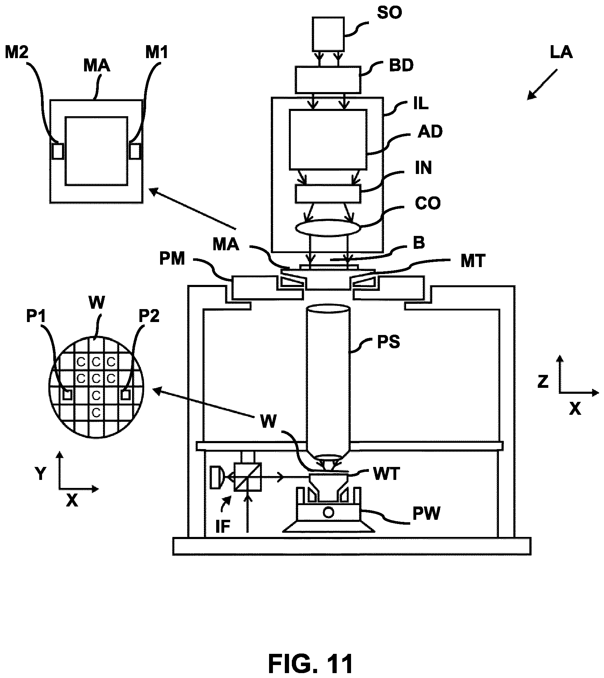

Fig. 11 schematically depicts an exemplary lithographic projection apparatus LA that may be utilized in conjunction with the techniques described herein. Lithographic apparatus LA may be the same as or similar to apparatus 10 illustrated in Fig. 1. Fig. 11 may illustrate several more components of such an apparatus, for example. The apparatus LA comprises an illumination system IL, to condition a beam B of radiation. In this example, the illumination system also comprises a radiation source SO. Apparatus LA comprises a first object table (e.g., patterning device table) MT provided with a patterning device holder to hold a patterning device MA (e.g., a reticle), and connected to a first positioner to accurately position the patterning device with respect to item PS. Apparatus LA comprises a second object table (substrate table) WT provided with a substrate holder to hold a substrate W (e.g., a resist-coated silicon wafer), and connected to a second positioner to accurately position the substrate with respect to item PS. Apparatus LA comprises a projection system ("lens") PS (e.g., a refractive, catoptric or catadioptric optical system) to image an irradiated portion of the patterning device MA onto a target portion C (e.g., comprising one or more dies) of the substrate W. In some embodiments, the apparatus LA is of a transmissive type (i.e., has a transmissive patterning device). However, in general, it may also be of a reflective type, for example (with a reflective patterning device). The apparatus may employ a different kind of patterning device relative to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander, for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Fig. 10 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or F₂ lasing).

The beam B subsequently intercepts the patterning device MA, which is held on a patterning device table MT. Having traversed the patterning device MA, the beam B passes through a lens, which focuses the beam B onto a target portion C of the substrate W. With the aid of the second positioning means (and interferometric measuring means IF), the substrate table WT can be moved accurately, e.g. so as to position different target portions C in the path of the beam B. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Fig. 11. However, in the case of a stepper (as opposed to a step-and-scan tool) the patterning device table MT may just be connected to a short stroke actuator, or may be fixed.

Apparatus LA may be used in step mode, where the patterning device table MT is kept essentially stationary, and an entire patterning device image is projected in one operation (i.e., a single "flash") onto a target portion C. The substrate table WT is then shifted in the x and/or y directions so that a different target portion C can be irradiated by the beam B. Apparatus LA may instead be used in scan mode, where a given target portion C is not exposed in a single "flash". Instead, the patterning device table MT is movable in a given direction (the "scan direction", e.g., the y direction) with a velocity configured such that the projection beam B is caused to scan over a patterning device image. Concurrently, the substrate table WT is simultaneously moved in the same or opposite direction at a speed V = Mv, in which M is the magnification of the lens (typically, M = 1/4 or 1/5). In this manner, a relatively large target portion C can be exposed, without having to compromise on resolution.

Various embodiments of the present systems and methods are disclosed in the subsequent list of numbered clauses. In the following, further features, characteristics, and exemplary technical solutions of the present disclosure will be described in terms of clauses that may be optionally claimed in any combination:
1. A method for training a machine learning model used by different participants for configuring a semiconductor manufacturing process, the method comprising: aligning time series data sets received from the different participants, each time series data set comprising different features corresponding to one or more samples common to each participant, the aligning configured to preserve privacy of each time series data set for each participant; receiving, from a first participant, first model parameters (H1) determined based on the aligning and first features provided by the first participant in a first time series data set; receiving, from a second participant, second model parameters (H2) determined based on the aligning, second features provided by the second participant in a second time series data set, and semiconductor manufacturing process outputs associated with the second features; and training the machine learning model based on the first model parameters and the second parameters.
2. The method of clause 1, further comprising, responsive to the training, using the machine learning model for inference, wherein the inference comprises: predicting needed maintenance for equipment used for the semiconductor manufacturing process, predicting part degradation and/or replacement need for one or more parts of the equipment, predicting a remaining useable life of the equipment, determining a feedforward correction for the semiconductor manufacturing process, determining a feedback correction for the semiconductor manufacturing process, and/or predicting a calibration setting for the equipment.
3. The method of any of the previous clauses, wherein the inference is based on new equipment operational and/or performance data, and/or new on product performance data associated with the semiconductor manufacturing process, and wherein the new equipment operational and/or performance data, and/or the new on product performance data is provided to the trained machine learning model to cause the trained machine learning model to output a predicted maintenance need, a predicted part degradation and/or replacement need, a predicted remaining useable life of the equipment, a feedforward correction, a feedback correction, and/or a predicted calibration setting.
4. The method of any of the previous clauses, further comprising pre-processing, for the second participant, the second time series data set and the second features, and further determining the second model parameters based on the pre-processing.
5. The method of any of the previous clauses, wherein the pre-processing comprises identifying an order of a time series process using autocorrelation and partial autocorrelation plots.
6. The method of any of the previous clauses, wherein identifying the order of the time series process comprises determining a number of autoregressive terms, a differencing order, moving average terms, and/or seasonal orders.
7. The method of any of the previous clauses, wherein the aligning, determining the first parameters, determining the second parameters, and training, are performed according to a vertical federated learning framework.
8. The method of any of the previous clauses, wherein the first and/or second parameters comprise weights, time series parameters including an order and a seasonal order, and/or a number of exogenous features.
9. The method of any of the previous clauses, wherein the one or more samples comprise semiconductor wafers.
10. The method of any of the previous clauses, wherein the features comprise semiconductor manufacturing process data values associated with equipment used for the semiconductor manufacturing process and/or products produced by the semiconductor manufacturing process.
11. The method of any of the previous clauses, wherein the features comprise data values associated with a lithographic apparatus and corresponding product performance data values.
12. The method of any of the previous clauses, wherein the data values are sensor reading values from a sensor of the lithographic apparatus.
13. The method of any of the previous clauses, wherein the sensor is one of: an alignment sensor, a leveling sensor, an aberration measurement sensor, a temperature sensor, a current and/or power sensor, a vibration sensor, an accelerometer, a pressure sensor, or an illuminance sensor .
14. The method of any of the previous clauses, wherein the product performance data values and/or outputs relate to one or more of: pattern position error (PPE), alignment residual error, overlay, focus error, Critical Dimension (CD), yield of the semiconductor manufacturing process, Edge Placement Error (EPE), defects, defect rate, or electrical test data.
15. The method of any of the previous clauses, wherein the aligning comprises entity alignment.
16. The method of any of the previous clauses, wherein entity alignment comprises a Private Set Intersection (PSI) scheme.
17. The method of any of the previous clauses, wherein the PSI scheme comprises signature-and-encryption and/or oblivious transfer.
18. The method of any of the previous clauses, wherein the semiconductor manufacturing process outputs associated with the second features are owned and kept private for the second participant.
19. The method of any of the previous clauses, wherein the different participants are physically located remotely from each other.
20. The method of any of the previous clauses, wherein: the participants comprise one active participant, and one or more auxiliary participants, there is one coordinator responsible for generating random data used for secure matrix multiplication, and does not have access to the time series data sets data, the random data generated by the coordinator is configured to be consumed by other participants during training, and secure matrix multiplication is used for optimizing machine learning model parameters and/or predictions.
21. The method of any of the previous clauses, further comprising providing an isolated computing environment for each participant using Intel Software Guard Extensions (SGX), or through a trusted third-party.
22. The method of any of the previous clauses, further comprising provided encrypted communication between the different participants, such that communications between pairs of participants are kept private and are not discoverable to other participants.
23. The method of any of the previous clauses, wherein the different participants are prevented from colluding with one another.
24. The method of any of the previous clauses, wherein the machine learning model comprises a neural network, a traditional time series model, and/or an autoregressive tree.
25. The method of any of the previous clauses, wherein the machine learning model comprises the neural network, and the neural network is trained using a variant of split learning architecture.
26. The method of any of the previous clauses, further comprising providing inferences from a trained neural network to participants by a federator.
27. The method of any of the previous clauses, wherein the machine learning model comprises the traditional time series model, and the traditional time series model is trained using secret sharing techniques for input feature values for autoregressive, moving average, and exogenous terms associated with the time series data sets from each participant.
28. The method of any of the previous clauses, wherein the machine learning model comprises the autoregressive tree, and the autoregressive tree is trained using secret sharing techniques and/or by communicating a maximum autoregressive lag, T, such that each participant can align their exogenous variables to start from a Tth step onward.
29. The method of any of the previous clauses, wherein each participant distributes local features or output using secret sharing to other participants, and each participant produces a local inference result which is aggregated by a requesting party, such that absence of a single federator provides flexibility in choosing an aggregator, and such that a participant requiring inference results can directly aggregate individual shares from other participants for obtaining a final result without having the federator act as a middleman.
30. A computer program product comprising a non-transitory computer readable medium having instructions recorded thereon, the instructions when executed by a computer implementing the method of any of the previous clauses.
31. A system comprising a computer configured to execute instructions stored on a non-transitory computer readable medium, the computer configured to implement the method of any of the previous clauses based on the instructions.
32. A computer program product comprising a non-transitory computer readable medium having instructions recorded thereon, the instructions defining a trained machine learning model configured to be executed by computers associated with different participants for configuring a semiconductor manufacturing process, wherein: the trained machine learning model is trained by: aligning time series data sets received from the different participants, each time series data set comprising different features corresponding to one or more samples common to each participant, the aligning configured to preserve privacy of each time series data set for each participant; receiving, from a first participant, first model parameters (H1) determined based on the aligning and first features provided by the first participant in a first time series data set; receiving, from a second participant, second model parameters (H2) determined based on the aligning, second features provided by the second participant in a second time series data set, and semiconductor manufacturing process outputs associated with the second features; and training the machine learning model based on the first model parameters and the second parameters.
33. The computer program product of clause 32, wherein the trained machine learning model is configured to be used for inference, wherein the inference comprises: predicting needed maintenance for equipment used for the semiconductor manufacturing process, predicting part degradation and/or replacement need for one or more parts of the equipment, predicting a remaining useable life of the equipment, determining a feedforward correction for the semiconductor manufacturing process, determining a feedback correction for the semiconductor manufacturing process, and/or predicting a calibration setting for the equipment.
34. The computer program product of any of clauses 32 to 33, wherein the inference is based on new equipment operational and/or performance data, and/or new on product performance data associated with the semiconductor manufacturing process, and wherein the new equipment operational and/or performance data, and/or the new on product performance data is provided to the trained machine learning model to cause the trained machine learning model to output a predicted maintenance need, a predicted part degradation and/or replacement need, a predicted remaining useable life of the equipment, a feedforward correction, a feedback correction, and/or a predicted calibration setting.
35. The computer program product of any of clauses 32 to 34, wherein, for the second participant, the second time series data set and the second features are pre-processed, and the second model parameters are determined based on the pre-processing.
36. The computer program product of any of clauses 32 to 35, wherein the pre-processing comprises identifying an order of a time series process using autocorrelation and partial autocorrelation plots.
37. The computer program product of any of clauses 32 to 36, wherein identifying the order of the time series process comprises determining a number of autoregressive terms, a differencing order, moving average terms, and/or seasonal orders.
38. The computer program product of any of clauses 32 to 37, wherein the aligning, determining the first parameters, determining the second parameters, and training, are performed according to a vertical federated learning framework.
39. The computer program product of any of clauses 32 to 38, wherein the first and/or second parameters comprise weights, time series parameters including an order and a seasonal order, and/or a number of exogenous features.
40. The computer program product of any of clauses 32 to 39, wherein the one or more samples comprise semiconductor wafers.
41. The computer program product of any of clauses 32 to 40, wherein the features comprise semiconductor manufacturing process data values associated with equipment used for the semiconductor manufacturing process and/or products produced by the semiconductor manufacturing process.
42. The computer program product of any of clauses 32 to 41, wherein the features comprise data values associated with a lithographic apparatus and corresponding product performance data values.
43. The computer program product of any of clauses 32 to 42, wherein the data values are sensor reading values from a sensor of the lithographic apparatus.
44. The computer program product of any of clauses 32 to 43, wherein the sensor is one of: an alignment sensor, a leveling sensor, an aberration measurement sensor, a temperature sensor, a current and/or power sensor, a vibration sensor, an accelerometer, a pressure sensor, or an illuminance sensor.
45. The computer program product of any of clauses 32 to 44, wherein the product performance data values and/or outputs relate to one or more of: pattern position error (PPE), alignment residual error, overlay, focus error, Critical Dimension (CD), yield of the semiconductor manufacturing process, Edge Placement Error (EPE), defects, defect rate, or electrical test data.
46. The computer program product of any of clauses 32 to 45, wherein the aligning comprises entity alignment.
47. The computer program product of any of clauses 32 to 46, wherein entity alignment comprises a Private Set Intersection (PSI) scheme.
48. The computer program product of any of clauses 32 to 47, wherein the PSI scheme comprises signature-and-encryption and/or oblivious transfer.
49. The computer program product of any of clauses 32 to 48, wherein the semiconductor manufacturing process outputs associated with the second features are owned and kept private for the second participant.
50. The computer program product of any of clauses 32 to 49, wherein the different participants are physically located remotely from each other.
51. The computer program product of any of clauses 32 to 50, wherein: the participants comprise one active participant, and one or more auxiliary participants, there is one coordinator responsible for generating random data used for secure matrix multiplication, and does not have access to the time series data sets data, the random data generated by the coordinator is configured to be consumed by other participants during training, and secure matrix multiplication is used for optimizing machine learning model parameters and/or predictions.
52. The computer program product of any of clauses 32 to 51, wherein an isolated computing environment is provided for each participant using Intel Software Guard Extensions (SGX), or through a trusted third-party.
53. The computer program product of any of clauses 32 to 52, wherein encrypted communication are provided between the different participants, such that communications between pairs of participants are kept private and are not discoverable to other participants.
54. The computer program product of any of clauses 32 to 53, wherein the different participants are prevented from colluding with one another.
55. The computer program product of any of clauses 32 to 54, wherein the trained machine learning model comprises a neural network, a traditional time series model, and/or an autoregressive tree.
56. The computer program product of any of clauses 32 to 55, wherein the trained machine learning model comprises the neural network, and the neural network is trained using a variant of split learning architecture.
57. The computer program product of any of clauses 32 to 56, wherein inferences from a trained neural network are provided to participants by a federator.
58. The computer program product of any of clauses 32 to 57, wherein the trained machine learning model comprises the traditional time series model, and the traditional time series model is trained using secret sharing techniques for input feature values for autoregressive, moving average, and exogenous terms associated with the time series data sets from each participant.
59. The computer program product of any of clauses 32 to 58, wherein the trained machine learning model comprises the autoregressive tree, and the autoregressive tree is trained using secret sharing techniques and/or by communicating a maximum autoregressive lag, T, such that each participant can align their exogenous variables to start from a Tth step onward.
60. The computer program product of any of clauses 32 to 59, wherein each participant distributes local features or output using secret sharing to other participants, and each participant produces a local inference result which is aggregated by a requesting party, such that absence of a single federator provides flexibility in choosing an aggregator, and such that a participant requiring inference results can directly aggregate individual shares from other participants for obtaining a final result without having the federator act as a middleman.
61. A system comprising a computer configured to execute the instructions recorded in the medium of any of clauses 32 to 60 that define the trained machine learning model.
62. A method comprising executing the instructions recorded in the medium of any of clauses 32 to 60 that define the trained machine learning model.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), KrF systems at 248 nm, DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

The descriptions above are intended to be illustrative, not limiting. Thus, it will be apparent to one skilled in the art that modifications may be made as described without departing from the scope of the claims set out below.

## Claims

1. A computer program product comprising a non-transitory computer readable medium having instructions recorded thereon, the instructions defining a trained machine learning model configured to be executed by computers associated with different participants for configuring a semiconductor manufacturing process, wherein:
the trained machine learning model is trained by:
aligning time series data sets received from the different participants, each time series data set comprising different features corresponding to one or more samples common to each participant, the aligning configured to preserve privacy of each time series data set for each participant;
receiving, from a first participant, first model parameters (H1) determined based on the aligning and first features provided by the first participant in a first time series data set;
receiving, from a second participant, second model parameters (H2) determined based on the aligning, second features provided by the second participant in a second time series data set, and semiconductor manufacturing process outputs associated with the second features; and
training the machine learning model based on the first model parameters and the second parameters.

2. The computer program product of claim 1, wherein the trained machine learning model is configured to be used for inference, wherein the inference comprises:
predicting needed maintenance for equipment used for the semiconductor manufacturing process,
predicting part degradation and/or replacement need for one or more parts of the equipment,
predicting a remaining useable life of the equipment,
determining a feedforward correction for the semiconductor manufacturing process,
determining a feedback correction for the semiconductor manufacturing process, and/or
predicting a calibration setting for the equipment.

3. The computer program product of claim 2, wherein the inference is based on new equipment operational and/or performance data, and/or new on product performance data associated with the semiconductor manufacturing process, and wherein the new equipment operational and/or performance data, and/or the new on product performance data is provided to the trained machine learning model to cause the trained machine learning model to output a predicted maintenance need, a predicted part degradation and/or replacement need, a predicted remaining useable life of the equipment, a feedforward correction, a feedback correction, and/or a predicted calibration setting.

4. The computer program product of any of claims 1 to 3, wherein, for the second participant, the second time series data set and the second features are pre-processed, and the second model parameters are determined based on the pre-processing.

5. The computer program product of claim 4, wherein the pre-processing comprises identifying an order of a time series process using autocorrelation and partial autocorrelation plots.

6. The computer program product of any of claims 1 to 5, wherein the aligning, determining the first parameters, determining the second parameters, and training, are performed according to a vertical federated learning framework.

7. The computer program product of any of claims 1 to 6, wherein the one or more samples comprise semiconductor wafers.

8. The computer program product of any of claims 1 to 7, wherein the features comprise semiconductor manufacturing process data values associated with equipment used for the semiconductor manufacturing process and/or products produced by the semiconductor manufacturing process.

9. The computer program product of any of claims 1 to 8, wherein the aligning comprises entity alignment and wherein the entity alignment comprises a Private Set Intersection (PSI) scheme.

10. The computer program product of any of claims 1 to 9, wherein the semiconductor manufacturing process outputs associated with the second features are owned and kept private for the second participant.

11. The computer program product of any of claims 1 to 10, wherein:
the participants comprise one active participant, and one or more auxiliary participants,
there is one coordinator responsible for generating random data used for secure matrix multiplication, and does not have access to the time series data sets data,
the random data generated by the coordinator is configured to be consumed by other participants during training, and
secure matrix multiplication is used for optimizing machine learning model parameters and/or predictions.

12. The computer program product of any of claims 1 to 11, wherein encrypted communication is provided between the different participants, such that communications between pairs of participants are kept private and are not discoverable to other participants.

13. The computer program product of any of claims 1 to 12, wherein the trained machine learning model comprises a neural network, a traditional time series model, and/or an autoregressive tree.

14. The computer program product of any previous claim, wherein inferences from the trained neural network are provided to participants by a federator.

15. The computer program product of any preceding claim, wherein each participant distributes local features or output using secret sharing to other participants, and each participant produces a local inference result which is aggregated by a requesting party, such that absence of a single federator provides flexibility in choosing an aggregator, and such that a participant requiring inference results can directly aggregate individual shares from other participants for obtaining a final result without having the federator act as a middleman.
